Europäisches Patentamt

European Patent Office

Office européen des brevets

(11) Publication number: **0 298 648**
**A2**

## EUROPEAN PATENT APPLICATION

(21) Application number: 88305907.3

(22) Date of filing: 29.06.88

(51) Int. Cl.⁴ **C04B 35/00 , H01L 39/24 , C01G 3/00**

(30) Priority: 10.07.87 DK 3578/87

(43) Date of publication of application:
**11.01.89 Bulletin 89/02**

(84) Designated Contracting States:
**AT BE CH DE FR GB GR IT LI LU NL SE**

(71) Applicant: Haldor Topsoe A/S
**Nymollevej 55**
**DK-2800 Lyngby(DK)**

(72) Inventor: Johansen, Keld
**Haspeholmsalle 4**
**DK-3600 Frederikssund(DK)**
Inventor: Pedersen, Erik
**Bybjervej 21**
**DK-2970 Horsholm(DK)**

(74) Representative: Hartley, David et al
**c/o Withers & Rogers 4 Dyer's Buildings**
**Holborn**
**London, EC1N 2JT(GB)**

(54) **A process for the preparation of a superconducting metal-oxide ceramic, crystalline compound.**

(57) Superconducting metal-oxide crystalline compounds having the general formula $(Me^1)_p(Me^2)_qCu_3O_xF_y$, wherein $Me^1$ is selected from Y, Sc and the lanthanides, $Me^2$ is Ba and/or Sr, p is 0.8-2.5, q is 0.8-3, x is 5-8.5 and y is 0-6, are prepared by reacting $Me^2$ peroxide in the molten state with oxides and optionally fluorides of $Me^1$ and Cu, possibly accompanied by $Me^2$ oxide. Since the reaction takes place in the melt of $Me^2$ peroxide, there is obtained a better contact between the reactants than it is possible in known solid state reactions, and the chance of obtaining large, very pure monocrystals. Especially the $Me^2$ peroxide renders it possible to obtain a compound in which Cu to a high degree is present in a higher state of oxidation than 2.

Particularly well defined end products are obtained when the reaction is carried out in a closed vessel with an oxygen-free atmosphere, whereby the peroxide alone is the source for the oxygen that can increase the oxidation state of the copper.

## A process for the preparation of a superconducting metal-oxide ceramic, crystalline compound

### Field and Background of the Invention

The present invention relates to a special process for the preparation of a superconducting metal-oxide ceramic, crystalline compound having the general formula $(Me^1)_p(Me^2)_qCu_3O_xF_y$, where $Me^1$ is one or more metals selected amongst yttrium, scandium and the rare earth metals (the lanthanides), $Me^2$ is barium and/or strontium, p is 0.8-2.5, q is 0.8-3, x is 5-8.5 and y is 0-6, in which process oxides and optionally fluorides of $Me^1$, $Me^2$ and Cu are reacted with each other at an elevated temperature.

It is known that metal-oxide ceramic compounds of this kind, which are frequently called Y-Ba-Cu-O and in which the metals are present in the oxidic form, possess superconducting properties at a substantially higher temperature than that known for classic superconductors (up to about 23 K), frequently up to above the boiling point of liquid nitrogen at atmospheric pressure. It is also known that a partial replacement of oxygen by fluorine may improve the superconducting properties.

Although the metals in compounds of this kind typically are yttrium, barium and copper, yttrium may be entirely or partly replaced by scandium and/or one or more lanthanides, and barium entirely or partly by strontium. In the materials of the kind so far known, copper is compulsory; it is known that the superconducting properties are improved concurrently with the degree to which copper is present at a higher oxidation state than 2, preferably predominantly or entirely in oxidation state 3. Known materials of the kind in question have, for example, the composition $YBa_2Cu_3O_z$, where z is a number 6 to about 8.5, or $La_{1.85}Ba_{0.15}CuO_4$.

Surveys of superconducting substances of the kind in question are, i.a., an article by Ron Dagani in Chemical & Engineering News, May 11, 1987, pp. 7-16, and by Ib Johannsen and Thomas Bjørnholm in Dansk Kemi 5, May, 1987, pp. 172-175. There is a bibliography in the latter.

It is known that such compounds can be prepared by a reaction in the solid phase between suitable compounds, e.g. oxides, carbonates or oxalates, in powder form under an oxygen-containing atmosphere; that the reaction must be conducted under a controlled temperature profile; and that the composition of the surrounding atmosphere is important, notably the partial pressure of oxygen. Hitherto one has always used barium oxide, BaO, the melting point of which is 1923° C, in such solid phase reactions; it is to be mentioned that strontium oxide, SrO, also has a high melting point, viz. 2430° C.

It has been found difficult to control the temperature profile of the reaction and the oxygen partial pressure of the atmosphere so closely as to obtain a well-defined product, especially a product in which the copper is present in a state of oxidation which to a high degree is above 2.

### Description of the Invention

It has now been surprisingly found that these difficulties can be overcome if as source of barium and/or strontium one at least partially employs barium peroxide $BaO_2$ and/or strontium peroxide $SrO_2$ and carries out the reaction in a melt of that peroxide or peroxides.

The melting point of barium peroxide is 450° C and that of strontium peroxide 215° C. Thus, it is simple to carry through the reaction, and it does not make heavy demands on the apparatus to carry out the reaction in the molten phase. The other components of the reaction mixture, most frequently CuO and $(Me^1)_2O_3$, are at least partly dissolved in the $Me^2$ peroxide melt during the reaction, and in any case the presence of the $Me^2$ peroxide as a melt ensures an intimate contact between the reagents and hence a reaction that will easily run to completion.

If it is desired that the oxygen in the product should be partly exchanged by fluorine, the latter can be preferably added as $Me^1$ fluoride or copper fluoride since both barium fluoride and strontium fluoride have high melting points, 1280° C and 1450° C, respectively.

The technical effect of using barium or strontium peroxide in the process is not only that it thereby becomes technically possible and simple to carry out the reaction in the molten phase but also that hereby the chance of crystallization of the desired product in an expedient crystal size is favoured and that the peroxide or peroxides can be employed as the predominant or only oxygen source, which improves the possibility of obtaining a product in which Cu to a substantial degree is present in an oxidation state above 2, particularly in oxidation state 3. Accordingly, the reaction may expediently be carried out in a closed vessel, which to a high degree renders it possible to control the process in a manner so as to result in compounds of a crystal size and an outer shape which is convenient for such products, or which may be easily converted thereto by working up. The best possible control of the reaction and the composition and properties of the final product is obtained if according to the invention the reaction is carried out in a closed vessel without the need of the presence of an oxygen-containing atmosphere, the oxygen addition desired thereby being generated solely by the $Me^2$ peroxide and the total oxygen content hence being fully controllable. An inert atmosphere may for instance be nitrogen, argon or mixtures thereof.

Since the liquid phase of $Me^2$ peroxide permits a high reaction rate, it offers good possibilites of obtaining perfect, large monocrystals and hence good superconducting properties. Expedient selection of the reaction temperature and temperature gradients, especially during the heating but to some degree even during the cooling, may improve this effect further.

According to the invention one may expediently prepare a superconducting crystalline compound having substantially the composition $YBa_2Cu_3O_8$, by reacting $Y_2O_3$, $BaO_2$ and $CuO$ with one another in proportions corresponding to the said composition.

The reaction is normally conducted in an autoclave allowing temperature regulation in the range from $0°C$ to $1100°C$, possibly even up to $1400°C$. As a rule it will be expedient to control the rate of the temperature increase, at least from a temperature below the m.p. of the $Me^2$ peroxide to the final temperature which in case of barium peroxide conveniently is about $950°C$, and in case of its partial or complete replacement by strontium peroxide possibly a little lower, in both cases, however, depending on the solubility of the $Me^1$ compound and the copper compound in the melt.

The process according to the invention is to be exemplified in the following.

## Example

In a mortar 1.13 g (0.005 mol) of $Y_2O_3$, 3.39 g (0.020 mol) of $BaO_2$ and 2.39 g (0.030 mol) of $CuO$ were comminuted thoroughly into powders and were placed in a closed vessel under a quite small amount of an oxygen-free atmosphere. The vessel was placed in an autoclave with facilities for programmed temperature control of the reaction vessel in the range of $0-1400°C$ and was heated here, the heating from $300°C$ to $950°C$ taking place at a rate of $143°C$ per hour. When the vessel had been held at $950°C$ for 18 hours, the heat supply was discontinued so that spontaneous cooling to room temperature took place.

After the vessel had been opened, the material formed was pressed to a tablet which exhibited a clear Meissner effect a little above the boiling point of liquid nitrogen at atmospheric pressure. The product formed corresponds to the composition approximately $YBa_2Cu_3O_8$.

## Claims

1. A process for the preparation of a superconducting metal-oxide ceramic, crystalline compound having the general formula $(Me^1)_p(Me^2)_qCu_3O_xF_y$, where $Me^1$ is one or more metals selected from yttrium, scandium and the lanthanides, $Me^2$ is barium and/or strontium, p a number 0.8 to 2.5, q a number 0.8 to 3, x a number 5 to 8.5 and y a number 0 to 6, in which process oxides and optionally fluorides of $Me^1$, $Me^2$ and $Cu$ are reacted with each other at an elevated temperature, **characterized** in that $Me^2$ at least in part is employed in the form of barium peroxide and/or strontium peroxide and in that the reaction takes place at a temperature above that at which $Me^2O_2$ forms a melt.

2. A process according to claim 1, **characterized** in that the reaction is carried out in a closed vessel.

3. A process according to claim 1 or 2, **characterized** in that the reaction is carried out in a closed vessel under an inert atmosphere.

4. A process according to anyone of the preceding claims, **characterized** in that $Y_2O_3$, $BaO_2$ and $CuO$ while excluding free oxygen are reacted with each other in proportions such that there is formed a superconducting crystalline compound substantially having the composition $YBa_2Cu_3O_8$.